# EUROPEAN PATENT APPLICATION

(11) **EP 3 641 124 A1**
(43) Date of publication of application: **22.04.2020**
(21) Application number: 18816806.6
(22) Date of filing: 01.06.2018
(51) Int. Cl.: H02N 2/18, H01L 41/053, H01L 41/113

(54) **POWER GENERATION DEVICE**

(30) Priority: 14.06.2017 JP 2017117153
(71) Applicant: Panasonic Intellectual Property Management Co., Ltd., Osaka-shi, Osaka 540-6207 (JP)
(72) Inventor: NAKAMURA, Takaya, Osaka-shi, Osaka 540-6207 (JP); FUDO, Kohei, Osaka-shi, Osaka 540-6207 (JP); TERAKAWA, Shogo, Osaka-shi, Osaka 540-6207 (JP)
(74) Representative: Grünecker Patent- und Rechtsanwälte PartG mbB
(86) International application number: PCT/JP2018/021120
(87) International publication number: WO 2018/230360

(57) **Abstract**

A power generation device includes a power generator that has a cantilever structure of which one end is a fixed end to be fixed and other end is a free end, and generates a power due to free vibration of the free end, a resin holder section on which the power generator is mounted, and a metallic rigid plate that is located such that the holder section is between the rigid plate and the power generator. The fixed end and the holder section are fixed to each other, and the holder section and the rigid plate are fixed to each other.

## Description

### TECHNICAL FIELD

The present disclosure relates a power generation device including a power generator having a cantilever structure which includes a piezoelectric element.

### BACKGROUND ART

In the related art, in a signal generation device such as a switch capable of remotely operating an electrical device, a technology in which the convenience of the signal generation device is improved by providing an actuator (power generation device) within the signal generation device is suggested (see, for example, PTL 1).

The signal generation device (power generation switch) described in PTL 1 includes an actuator (power generator) having a cantilever structure which includes a piezoelectric element and a switch (arm section) of which a shape in section view is an L shape. When the switch is pressed, the switch and a free end of the actuator are in contact with each other, and thus, the actuator is bent. Accordingly, the switch is separated from the actuator, and thus, the actuator starts the free vibration, and generates a voltage due to a voltage effect. Accordingly, the signal generation device without requiring a battery is realized.

### Citation List

### Patent Literature

PTL 1: Unexamined Japanese Patent Publication No. 2004-201376

### SUMMARY OF THE INVENTION

A power generation device according to an aspect of the present disclosure includes a power generator having a cantilever structure of which one end is a fixed end to be fixed and other end is a free end, the power generator generating a power due to free vibration of the free end, a holder section comprising resin, the power generator being mounted on, and a rigid plate comprising metal, the rigid plate being located such that the holder section interposed is between the rigid plate and the power generator. The fixed end and the holder section are fixed to each other, and the holder section and the rigid plate are fixed to each other.

### BRIEF DESCRIPTION OF DRAWINGS

FIG. 1 is a perspective view illustrating an appearance of a button side of a power generation switch according to a first exemplary embodiment.
FIG. 2 is a perspective view illustrating an appearance of a case side of the power generation switch according to the first exemplary embodiment.
FIG. 3 is a perspective view illustrating a configuration of the power generation switch according to the first exemplary embodiment in a state in which a button and a case are omitted in FIG. 1.
FIG. 4 is an exploded perspective view illustrating a configuration of the power generation switch according to the first exemplary embodiment in a state in which the button and the case are omitted in FIG. 1.
FIG. 5 is an exploded perspective view illustrating a configuration of a power generation device according to the first exemplary embodiment.
FIG. 6 is a partial cross-sectional view of a power generator according to the first exemplary embodiment taken along line VI-VI of FIG. 5.
FIG. 7 is an exploded perspective view for describing a fixed state of a holder section and a rigid plate according to the first exemplary embodiment.
FIG. 8 is a plan view illustrating an appearance of the arm section according to the first exemplary embodiment.
FIG. 9 is a plan view illustrating an appearance of a button lower part according to the first exemplary embodiment.
FIG. 10 is a cross-sectional view for describing that the power generator generates the power by rotating the arm section according to the first exemplary embodiment.
FIG. 11 is a schematic diagram illustrating movement of the arm section and the lever section when the button according to the first exemplary embodiment is operated.
FIG. 12 is a schematic cross-sectional view of the power generation switch according to the first exemplary embodiment in a state of FIG. 11.
FIG. 13 is a partial exploded perspective view illustrating a configuration of a power generation switch according to a second exemplary embodiment.
FIG. 14 is a perspective view illustrating an outline of operations of an arm section and a reinforcement arm section when a button according to the second exemplary embodiment is operated.
FIG. 15 is a side view illustrating an outline of the operations of the arm section and the reinforcement arm section when the button according to the second exemplary embodiment is operated.

### DESCRIPTION OF EMBODIMENTS

In the actuator that generates the power due to the free vibration as in PTL 1 described above, it is desirable that the free vibration be restrained from being attenuated.

An object of the present disclosure is to provide a power generation device in which attenuation of free vibration is restrained.

### (Outline of present disclosure)

In order to achieve the aforementioned object, a power generation device according to an aspect of the present disclosure includes a power generator that has a cantilever structure of which one end is a fixed end to be fixed and other end is a free end, and generates a power due to free vibration of the free end, a resin holder section on which the power generator is mounted, and a metallic rigid plate that is disposed on a side opposite to the power generator with the holder section interposed therebetween. The fixed end and the holder section are fixed to each other, and the holder section and the rigid plate are fixed to each other.

Accordingly, it is possible to increase a weight of the power generation device compared to a case where the rigid plate is not provided. The rigid plate is disposed on an opposite side to the power generator, and thus, it is possible to increase a size of the rigid plate compared to a case where the rigid plate is disposed on the same surface as the power generator. Thus, since the weight of the power generation device is efficiently increased, the free vibration of the power generator can be further continued as compared to the related art. In other words, in accordance with the power generation device according to the present exemplary embodiment, it is possible to further restrain the free vibration of the power generator from being attenuated compared to the related art.

The fixed end, the holder section, and the rigid plate may be overlapped in contact with each other in this order, and may be fixed by using a common fixing member. The fixing member may be a screw that fixes the fixed end, the holder section, and the rigid plate by penetrating through the fixed end, the holder section, and the rigid plate.

Accordingly, the fixed end, the holder section, and the metallic rigid plate are fastened by the screw penetrating the fixed end, the holder section, and the metallic rigid plate. As a result, a fastening force between the power generator and the holder section can be improved. Accordingly, it is possible to further continue the free vibration of the power generator.

The power generation device may further include a housing that accommodates the power generator, the holder section, and the rigid plate. The housing and the rigid plate may be fixed by a screw.

Accordingly, since it is possible to improve the fastening force compared to a case where the case is fastened to the resin holder section, it is possible to restrain the free vibration from being attenuated by the variations in the fastening force of the case and the holder section.

A recess corresponding to a shape of the rigid plate may be formed on a surface of the holder section at a side on which the rigid plate is disposed, and the rigid plate may be accommodated in the recess.

Accordingly, it is possible to increase the weight of the power generation device while restraining the size of the power generation device from being increased.

The rigid plate may be made of a non-magnetic material.

Accordingly, it is possible to restrain the influence of the rigid plate on the free vibration of the power generator.

The power generation device may further include an attraction member that is fixed to the free end, and an arm section that extends in a coupling direction of the free end and the fixed end, the arm section pivotally supported on the fixed end, the arm section including a magnet that is attached to or released from the attraction member by the rotation of the magnet.

Accordingly, the power generation device can be used as the power generation switch.

Hereinafter, exemplary embodiments are more specifically described with appropriate reference to drawings. However, redundantly detailed description may be omitted. For example, detailed description of any already well-known matter and duplicate description of substantially identical configurations may be omitted. This is to avoid unnecessary redundancy of the following description and facilitate understanding by those skilled in the art. The drawings are also schematic diagrams and are not always exactly illustrated.

In the drawings used in the description of the following exemplary embodiments, coordinate axes may be illustrated. A minus side on a Z-axis represents an installation surface side, and a plus side on the Z-axis represents an operation surface side. An X-axis direction and a Y-axis direction are directions perpendicular to each other on a plane perpendicular to a Z-axis direction. An X-Y plane is a plane parallel to a top plate included in a power generation switch. For example, in the following exemplary embodiments, "plan view" means that the power generation switch is viewed in the Z-axis direction. For example, in the following exemplary embodiments, "section view" means the power generation switch cut along a surface including a cutting line is viewed in a direction perpendicular to the cut surface. For example, when the power generation switch is cut by a plane (an example of a surface cut by a cutting line) defined by the Y-axis and the Z-axis, the section view means that the cross section is viewed in the X-axis direction.

### (First exemplary embodiment)

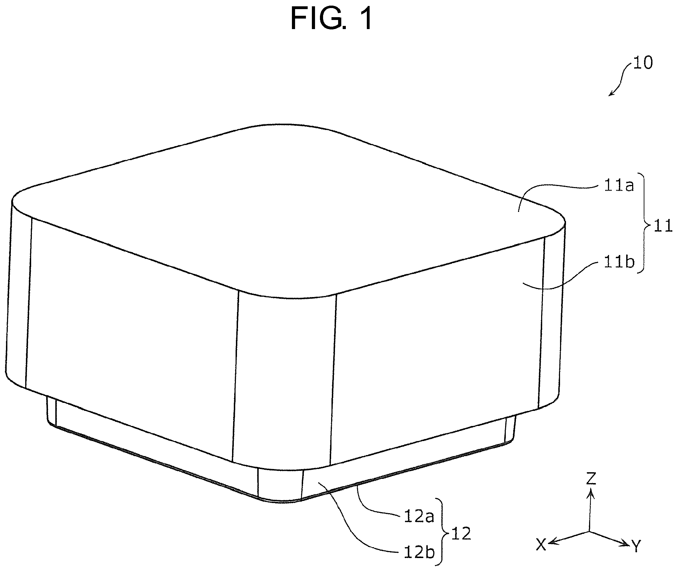

Hereinafter, power generation switch 10 according to the present exemplary embodiment will be described with reference to FIGS. 1 to 12.

### [1-1. Entire configuration of power generation switch]

Initially, a configuration of power generation switch 10 according to the present exemplary embodiment will be described with reference to FIGS. 1 to 9.

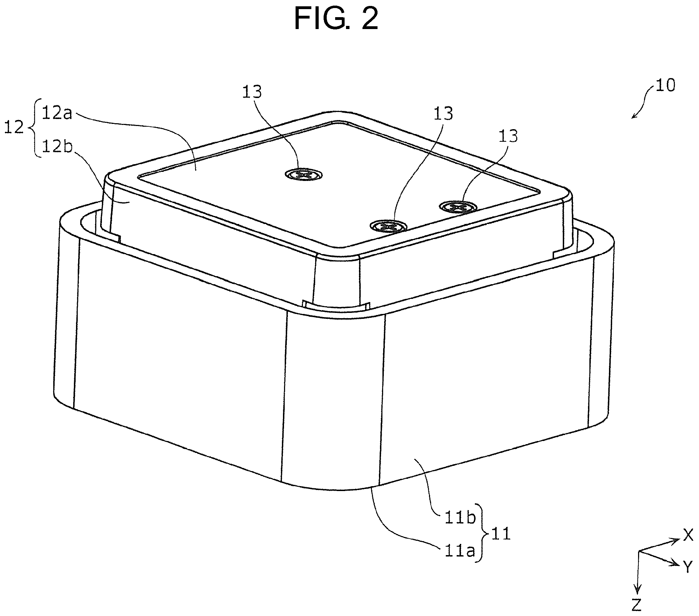

FIG. 1 is a perspective view illustrating an appearance of power generation switch 10 according to the present exemplary embodiment on button 11 side. FIG. 2 is a perspective view illustrating an appearance of power generation switch 10 according to the present exemplary embodiment on case 12 side.

Power generation switch 10 according to the present exemplary embodiment is a switch that is used for generating a power by operating (for example, pushing) button 11 and wirelessly transmitting a predetermined signal by using the generated power. That is, power generation switch 10 according to the present exemplary embodiment does not include a battery, and transmits the predetermined signal by generating the power whenever power generation switch 10 is operated.

The predetermined signal is, for example, a signal indicating unique identification information assigned to each power generation switch 10. Power generation switch 10 transmits the predetermined signal to a control device (not illustrated) that controls various electrical devices (for example, lighting devices, image display devices, and electric curtains) installed in a house. For example, when the identification information of power generation switch 10 and control for turning on the lighting device are associated with each other in the control device, the control device performs control for turning on the lighting device in response to the acquisition of the signal from power generation switch 10.

Power generation switch 10 according to the present exemplary embodiment is a switch capable of being carried by a user. For example, when the user works at a desk, the user may place power generation switch 10 on the desk, and when the user sleeps, the user may place power generation switch 10 beside bedding.

As illustrated in FIGS. 1 and 2, power generation switch 10 includes button 11 and case 12. Button 11 and case 12 form an outer shell of power generation switch 10.

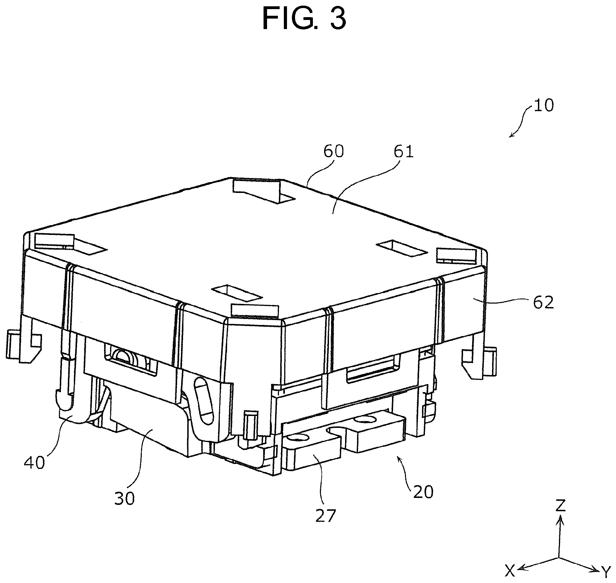

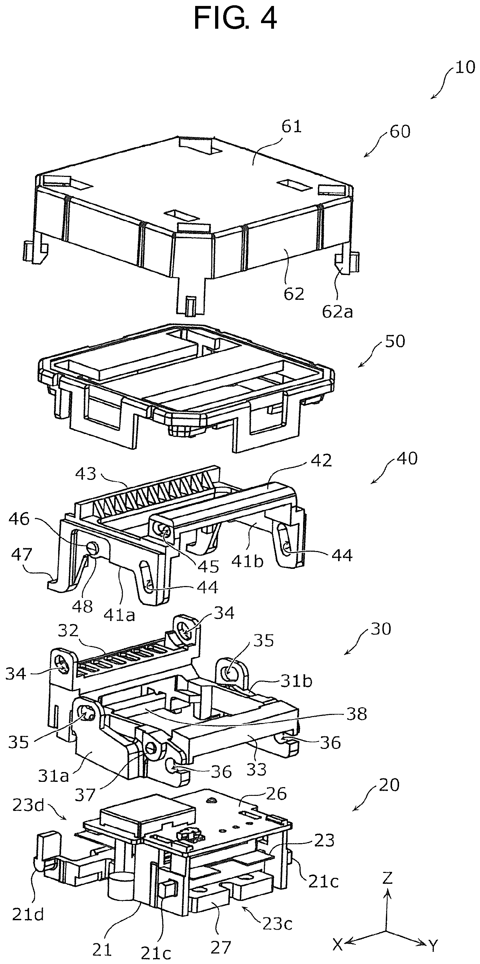

Next, components accommodated in button 11 and case 12 will be described with reference to FIGS. 3 and 4.

FIG. 3 is a perspective view illustrating the configuration of power generation switch 10 according to the present exemplary embodiment in a state in which button 11 and case 12 are omitted in FIG. 1. FIG. 4 is an exploded perspective view illustrating the configuration of power generation switch 10 according to the present exemplary embodiment in a state in which button 11 and case 12 are omitted in FIG. 1.

As illustrated in FIGS. 3 and 4, power generation switch 10 according to the present exemplary embodiment includes power generation device 20, arm section 30, lever section 40, cover 50, and button lower part 60 in a state in which button 11 and case 12 are omitted.

Hereinafter, the components constituting power generation switch 10 will be descried with appropriate reference to the drawings.

### [1-1-1. Button and case]

Button 11 and case 12 will be described with reference to FIGS. 1 and 2.

As illustrated in FIGS. 1 and 2, each of button 11 and case 12 has a bottom. Button 11 includes upper surface 11a and side surface 11b vertically formed toward case 12 side from an outer edge of upper surface 11a, and case 12 includes bottom surface 12a and side surface 12b vertically formed toward button 11 side from an outer edge of bottom surface 12a. In plan view, button 11 and case 12 are formed in a substantially rectangular shape in which four corners each have an R shape. For example, button 11 and case 12 are formed in a substantially square shape in which four corners each have an R shape.

In plan view, a size of button 11 is greater than a size of case 12. That is, button 11 is disposed such that upper surface 11a is opposite to bottom surface 12a of case 12 and side surface 11b of button 11 covers a part of side surface 12b of case 12. Power generation device 20, arm section 30, and lever section 40 to be described below are accommodated in a space formed by button 11 and case 12.

Upper surface 11a is an operation surface operated by the user. Specifically, the user presses upper surface 11a. Accordingly, button 11 is pressed toward an installation surface on which power generation switch 10 is placed (in the present exemplary embodiment, toward the Z-axis minus side from the Z-axis plus side).

Button 11 and case 12 are made of a resin material. For example, button 11 and case 12 are made of an acrylic resin, a polycarbonate resin, polybutylene terephthalate (PBT), polyoxymethylene (POM), or an ABS resin (a copolymer of acrylonitrile, butadiene, and styrene). The material of button 11 and case 12 is not limited thereto. Button 11 and case 12 may be made of the same material, or may be made of different materials. Button 11 and case 12 may be made of a colored resin material. That is, the user is not able to visually perceive the components accommodated in the space formed by button 11 and case 12. Accordingly, it is possible to improve an aesthetic appearance of power generation switch 10.

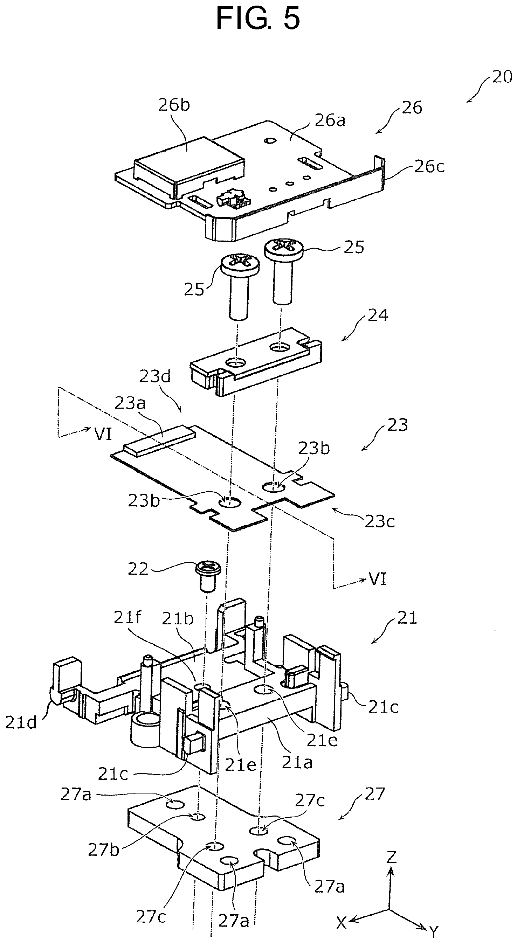

As illustrated in FIG. 2, three openings are formed in bottom surface 12a of case 12, and screws 13 are attached to the openings. Case 12 is screwed to rigid plate 27 (see FIG. 5) to be described below by using screws 13.

Case 12 is in contact with the installation surface (for example, a desk surface or a floor surface) on which power generation switch 10 is placed. Case 12 is an example of a housing.

Top plate 61 of button lower part 60 illustrated in FIG. 3 and upper surface 11a of button 11 are fixed. For example, a surface (an upper surface of top plate 61 in FIG. 3) of top plate 61 on the Z-axis plus side and a surface (a lower surface of upper surface 11a in FIG. 1) of upper surface 11a of button 11 on the Z-axis minus side are bonded by using an adhesive tape, and thus, button lower part 60 and button 11 are fixed. The fixing of button lower part 60 and button 11 is not limited to the fixing using the adhesive tape, and may be fixed such that button 11 is not separated from button lower part 60. For example, button lower part 60 and button 11 may be screwed to each other by using a screw, or may be fixed by other fixing methods.

### [1-1-2. Power generation device]

Power generation device 20 will be described with reference to FIGS. 3 to 6.

FIG. 5 is an exploded perspective view illustrating the configuration of power generation device 20 according to the present exemplary embodiment.

As illustrated in FIGS. 3 and 4, power generation device 20 is disposed on a lower side (Z-axis minus side) in a state in which button 11 and case 12 are omitted.

As illustrated in FIG. 5, power generation device 20 includes holder section 21, power generator 23, screw holder section 24, signal transmitter 26, and rigid plate 27. Power generation device 20 includes fixing members for fixing holder section 21 and rigid plate 27 and fixing one end side of power generator 23 and holder section 21. In the present exemplary embodiment, power generation device 20 includes, as the fixing members, a screw 22 for screwing holder section 21 and rigid plate 27 together and screws 25 for screwing one end side of power generator 23 and holder section 21 together. The fixing of holder section 21 and rigid plate 27 and the fixing of power generator 23 and holder section 21 are not limited to the screwing. That is, the fixing members are not limited to screws 22 and 25. For example, holder section 21 and rigid plate 27, and power generator 23 and holder section 21 may be fixed by using an adhesive, or may be fixed by other methods.

Holder section 21 includes first holder 21a, second holder 21b, first protrusions 21c, and second protrusions 21d. For example, first holder 21a, second holder 21b, first protrusions 21c, and second protrusions 21d are integrally formed. First holder 21a and second holder 21b are formed so as to be connected to each other. In FIG. 5, first holder 21a is disposed on a Y-axis plus side, and second holder 21b is disposed on a Y-axis minus side.

A thickness (a length in the Z-axis direction) of first holder 21a is greater than a thickness of second holder 21b, and first holder 21a protrudes toward the Z-axis plus side from second holder 21b. Two first opening parts 21e are formed in first holder 21a. First opening parts 21e are screw holes for fixing power generator 23 to holder section 21 (specifically, first holder 21a). For example, power generator 23 is fixed to holder section 21 by using screws 25. Power generator 23 fixed to first holder 21a is not in contact with second holder 21b.

Second opening part 21f having one opening is formed in second holder 21b. Second opening part 21f is a screw hole for fixing rigid plate 27 to holder section 21. For example, rigid plate 27 and holder section 21 are fixed by using screw 22.

As stated above, power generator 23 is fixed to one surface (the surface on the Z-axis plus side illustrated in FIG. 5) of holder section 21, and rigid plate 27 is fixed to the other surface (the surface on the Z-axis minus side illustrated in FIG. 5) opposite to one surface.

First protrusions 21c are formed so as to protrude from sides of first holder 21a in the X-axis direction. First protrusions 21c include a protrusion protruding from an end of first holder 21a on the X-axis plus side toward the X-axis plus side, and a protrusion protruding from an end of first holder 21a on the X-axis minus side toward the X-axis minus side. When viewed in the X-axis direction, an outer shape of first protrusion 21c is a substantially oval shape of which a major axis is a vertical direction (that is, Z-axis direction). First protrusions 21c are a rotary shaft for rotating arm section 30 to be described below.

Second protrusions 21d are formed so as to protrude from sides of second holder 21b in the X-axis direction. Second protrusions 21d include a protrusion protruding from an end of second holder 21b on the X-axis plus side toward the X-axis plus side, and a protrusion protruding from an end of second holder 21b on the X-axis minus side toward the X-axis minus side. For example, second protrusions 21d are formed at the ends of second holder 21b on an opposite side to first holder 21a. When viewed in the X-axis direction, an outer shape of second protrusion 21d is a substantially semicircular shape having an arc in a Z-axis minus direction. Second protrusions 21d are a rotary shaft for rotating lever section 40 to be described below.

Holder section 21 is made of a resin material. For example, holder section 21 is made of an acrylic resin, a polycarbonate resin, polybutylene terephthalate (PBT), polyoxymethylene (POM), or an ABS resin (a copolymer of acrylonitrile, butadiene, and styrene).

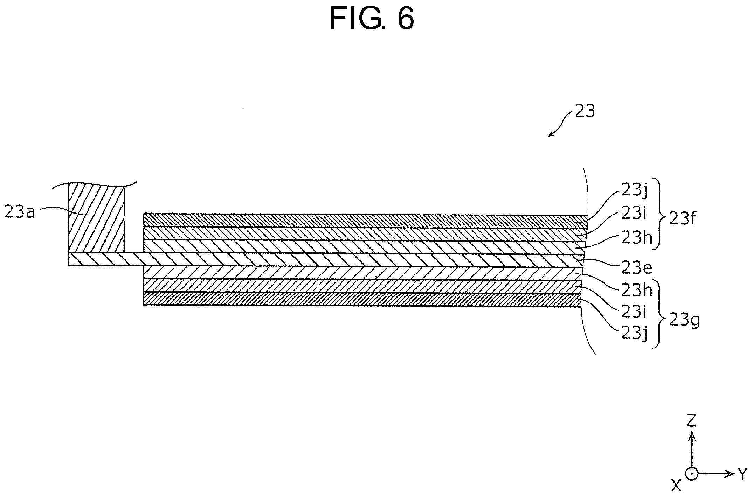

Power generator 23 includes a magnetic plate 23a and piezoelectric elements 23f, 23f (see FIG. 6), and generates a voltage due to a piezoelectric effect by bending and vibrating. Power generator 23 is formed in a flat plate shape, and two opening parts 23b are formed in one end side. Opening parts 23b are openings for fixing power generator 23 to holder section 21. For example, power generator 23 and holder section 21 (specifically, first holder 21a) are screwed to each other through screw holder section 24 by using screws 25. That is, power generator 23 has a cantilever structure in which one end (in the present exemplary embodiment, an end on a Y-axis plus side) is fixed end 23c to be fixed and the other end (in the present exemplary embodiment, an end on a Y-axis minus side) is free end 23d. Free end 23d freely vibrates, and thus, power generator 23 generates the power. That is, power generator 23 includes fixed end 23c fixed to holder section 21 and free end 23d that freely vibrates. Free end 23d freely vibrates, and thus, the power generator generates the power.

Magnetic plate 23a is made of a magnetic material, and is fixed to an end on free end 23d side. The magnetic plate is an example of an attraction member that attracts magnet 38 (see FIG. 4) included in arm section 30 to be described below by a magnetic force.

Magnetic plate 23a may be fixed to a tip on free end 23d side of power generator 23. Accordingly, magnetic plate 23a can also serve as a weight of power generator 23.

Hereinafter, a structure of power generator 23 will be described with reference to FIG. 6.

FIG. 6 is a partial cross-sectional view of power generator 23 according to the present exemplary embodiment taken along line VI-VI of FIG. 5.

Power generator 23 includes thin metal plate 23e and the piezoelectric element disposed on at least one surface of metal plate 23e. As illustrated in FIG. 6, in the present exemplary embodiment, power generator 23 includes thin metal plate 23e, and thin piezoelectric elements 23f and 23g arranged on both surfaces of metal plate 23e. Specifically, piezoelectric element 23f is disposed on signal transmitter 26 side of metal plate 23e, and piezoelectric element 23g is disposed on holder section 21 side of metal plate 23e. That is, power generator 23 includes two piezoelectric elements 23f and 23g, and two piezoelectric elements 23f and 23g are arranged so as to sandwich metal plate 23e. For example, piezoelectric element 23g, metal plate 23e, and piezoelectric element 23f are layered in contact with each other in this order. Accordingly, it is possible to generate high power through free vibration compared to a case where one piezoelectric element is provided.

Metal plate 23e is made of a spring material. For example, a metallic material such as a stainless steel may be used as metal plate 23e.

Piezoelectric element 23f is formed such that electrode 23h, piezoelectric member 23i, and electrode 23j are layered in contact with each other in this order toward the Z-axis plus side from metal plate 23e. Further, piezoelectric element 23g is formed such that electrode 23h, piezoelectric member 23i, and electrode 23j are layered in contact with each other in this order toward the Z-axis minus side from metal plate 23e. Electrodes 23h and 23j are electrodes for outputting the voltage generated by piezoelectric member 23i. Electrodes 23h and 23j may be made of a metallic material, or may be made of an oxide conductor material.

Electrode 23h of piezoelectric element 23f and electrode 23h of piezoelectric element 23g are electrodes having the same polarity. Electrode 23j of piezoelectric element 23f and electrode 23j of piezoelectric element 23g are electrodes which have the same polarity and have polarity opposite to the polarity of electrodes 23h. For example, when electrode 23j is a positive electrode, electrode 23h is a negative electrode, and when electrode 23j is a negative electrode, electrode 23h is a positive electrode. The power generated by power generator 23 is output to signal transmitter 26 through a power line (not illustrated).

Although not illustrated, power generator 23 may include a rectifier and a voltage regulator. An alternating current (AC) power generated by free vibration of free end 23d is converted into a direct current (DC) power by a rectifier including a rectifier circuit and a capacitor, and is stored. A voltage of the DC power is several tens of volts, and is, for example, about 50 V. The voltage is stepped down by a voltage regulator such as a DC-to-DC converter such that an excessive voltage is not applied to signal transmitter 26. For example, the voltage is stepped down to about 3 V by the voltage regulator, and the stepped-down voltage is used by signal transmitter 26, as a power for transmitting the signal.

Referring back to FIG. 5, the signal generator will be described. When the power is supplied from power generator 23, signal transmitter 26 is a device that wirelessly transmits a predetermined signal by using the power. In other words, signal transmitter 26 operates by only the power supplied from power generator 23. Wireless communication is wireless communication using a communication standard of, for example, ZigBee (registered trademark), but is not limited thereto. For example, wireless communication using a communication standard such as a wireless LAN (for example, Wi-Fi (registered trademark)) may be used.

Signal transmitter 26 includes substrate 26a, shield case 26b, and antenna 26c.

Substrate 26a is a substrate on which an electrical circuit including a transmission integrated circuit (IC) for transmitting a signal is mounted. For example, when the power is supplied from power generator 23, the transmission IC performs control for generating a predetermined signal and transmitting the generated signal through antenna 26c. As described above, the predetermined signal is information indicating unique identification information for each power generation switch 10. That is, the transmission IC performs control for transmitting the same signal whenever the power is supplied from power generation device 20. A wire-to-substrate connector for receiving the power from power generator 23 may be mounted on substrate 26a.

Shield case 26b is made of a metallic material, and is fixed to substrate 26a. In order to protect the electrical circuit from static electricity and external radio wave noise, shield case 26b is connected to a ground potential on the circuit.

Antenna 26c is a transmitter that transmits the signal generated in substrate 26a. Antenna 26c is made of, for example, a metallic material. Antenna 26c is electrically connected to the electrical circuit of substrate 26a. When substrate 26a is viewed in plan view, antenna 26c is disposed so as to face an edge on fixed end 23c side of substrate 26a.

Rigid plate 27 is a weight fixed to holder section 21. Rigid plate 27 is, for example, a metal plate. Rigid plate 27 is disposed on a side opposite to power generator 23 with holder section 21 interposed therebetween. Rigid plate 27 is made of, for example, a non-magnetic material such as a stainless steel. A thickness of rigid plate 27 is not particularly limited, and is, for example, about 2 mm. Rigid plate 27 may be made of a magnetic material.

When power generator 23 freely vibrates, the free vibration is preferably hard to be attenuated. Rigid plate 27 is fixed to holder section 21, and thus, power generation device 20 (power generation switch 10) becomes heavy. Thus, it is possible to maintain the free vibration of power generator 23 for a long time. That is, since it is possible to restrain the attenuation of the free vibration of power generator 23, a power generation efficiency of power generation device 20 is improved.

First opening parts 27a, second opening part 27b, and third opening parts 27c are formed in rigid plate 27. For example, screw taps may be cut in first opening parts 27a, second opening part 27b, and third opening parts 27c.

First opening parts 27a are screw holes for fixing case 12 to rigid plate 27, and one opening part is formed on free end 23d side (in other words, the Y-axis minus side) of rigid plate 27, and two opening parts are formed on fixed end 23c side (in other words, the Y-axis plus side) of rigid plate 27. In the description above and below, free end 23d side means a side corresponding to a side of free end 23d of power generator 23, and fixed end 23c side means a side corresponding to a side of fixed end 23c of power generator 23. As described above, three screw holes are formed in bottom surface 12a of case 12. In plan view, the screw holes formed in bottom surface 12a of case 12 and first opening parts 27a are formed at overlapping positions, and case 12 and rigid plate 27 are fixed by using screws 13.

Second opening part 27b is a screw hole for fixing holder section 21 to rigid plate 27, and is one. As described above, second opening part 21f is formed in second holder 21b of holder section 21. In plan view, second opening part 27b and second opening part 21f are formed at an overlapping position, and holder section 21 and rigid plate 27 are fixed by using screw 22.

Third opening parts 27c are screw holes for fixing fixed end 23c of power generator 23, holder section 21, and rigid plate 27 by using common fixing members, and two opening parts are formed in rigid plate 27 on fixed end 23c side. As described above, opening parts 23b having two screw holes are formed in power generator 23, and first opening parts 21e having two screw holes are formed in first holder 21a of holder section 21. In plan view, third opening parts 27c, opening parts 23b, and first opening parts 21e are formed at overlapping positions, and fixed end 23c, holder section 21, and rigid plate 27 are fixed by using screws 25. For example, fixed end 23c of power generator 23, first holder 21a of holder section 21, and rigid plate 27 are overlapped in contact with each other in this order, and are fixed by using screws 25. Screws 25 are an example of the common fixing members for fixing fixed end 23c, holder section 21, and rigid plate 27.

As stated above, rigid plate 27 is fixed to both holder section 21 and case 12. Thus, rigid plate 27 may be disposed on a surface opposite to power generator 23 with holder section 21 interposed therebetween.

When fixed end 23c and holder section 21 are not fixed to rigid plate 27 by using the screws, first opening parts 27a, second opening part 27b, and third opening part 27c may not be formed in rigid plate 27.

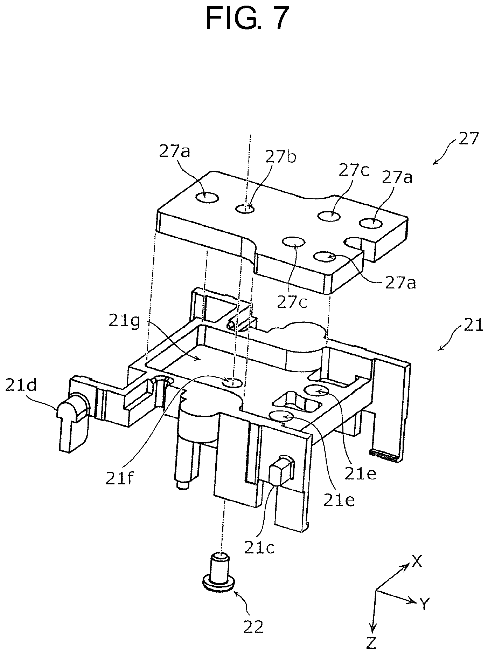

Hereinafter, the fixing of holder section 21 and rigid plate 27 will be described in more detail with reference to FIG. 7.

FIG. 7 is an exploded perspective view for describing a fixed state of holder section 21 and rigid plate 27 according to the present exemplary embodiment.

As illustrated in FIG. 7, recess 21g corresponding to the shape of rigid plate 27 is formed in a surface on rigid plate 27 side of holder section 21. Rigid plate 27 is fitted into recess 21g of holder section 21, and is fixed by using screw 22. A thickness (a length in the Z-axis direction) of recess 21g and a thickness of rigid plate 27 are substantially equal to each other. Thus, the surface on rigid plate 27 side of holder section 21 in which rigid plate 27 is accommodated in recess 21g is a smooth surface.

### [1-1-3. Arm section]

Arm section 30 will be described with reference to FIGS. 3, 4, and 8.

As illustrated in FIG. 3, arm section 30 is covered by button lower part 60. Accordingly, button lower part 60 is pressed, and thus, arm section 30 can be pressed and rotated.

As illustrated in FIG. 4, arm section 30 includes arm 31a, arm 31b, first connecting part 32, second connecting part 33, and magnet 38. First opening parts 34 are formed on free end 23d side (Y-axis minus side) of arms 31a and 31b. Second opening parts 35 are formed between ends on free end 23d side and ends on fixed end 23c side (Y-axis plus side) of arms 31a and 31b. Third opening part 36 are formed on fixed end 23c side of arms 31a and 31b.

Arms 31a and 31b extend in a coupling direction of free end 23d and fixed end 23c of power generator 23, and are arranged substantially parallel to each other. In plan view, arms 31a and 31b are arranged in parallel with each other in a direction perpendicular to the coupling direction of free end 23d and fixed end 23c so as to sandwich power generator 23. The coupling direction of free end 23d and fixed end 23c is a direction parallel to the Y-axis in the present exemplary embodiment. The direction perpendicular to the coupling direction of free end 23d and fixed end 23c is a direction parallel to the X-axis in the present exemplary embodiment.

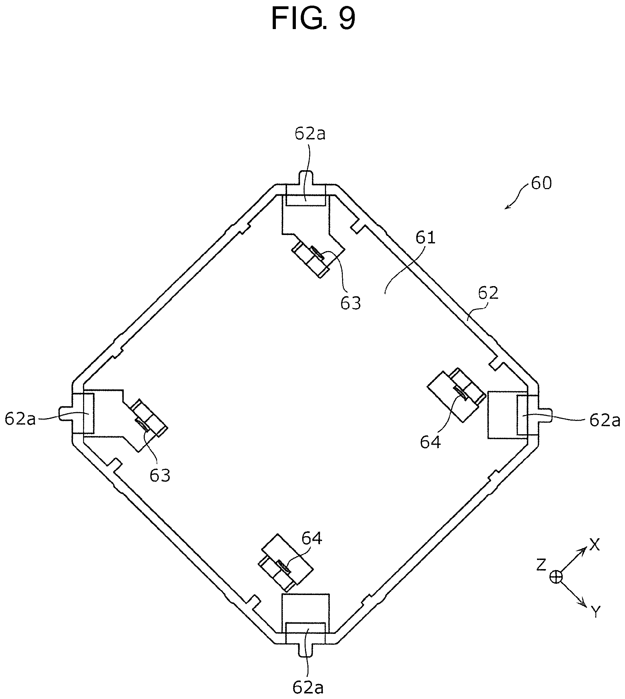

The ends on free end 23d side of arm 31a and 31b are fixed to button lower part 60. Specifically, first opening parts 34 formed in arms 31a and 31b and first protrusions 63 (see FIG. 9) formed in button lower part 60 are fitted to each other, and thus, arm section 30 and button lower part 60 are attached.

The ends on fixed end 23c side of arms 31a and 31b are attached to power generation device 20 so as to be rotated. Specifically, third opening parts 36 formed in arms 31a and 31b have shapes corresponding to first protrusions 21c, and third opening parts 36 and first protrusions 21c are fitted to each other. Thus, arm section 30 is pivotally supported by first protrusions 21c. Accordingly, arm section 30 is attached to power generation device 20 so as to be rotated with first protrusions 21c as the rotary shaft. For example, when viewed in the X-axis direction, the outer shapes of third opening parts 36 and first protrusions 21c are substantially circular shapes.

In plan view, first protrusions 37 protruding outward of power generation switch 10 are formed at the ends on fixed end 23c side of arms 31a and 31b. Specifically, first protrusion 37 protruding toward the side (in other words, the X-axis plus side) opposite to arm 31b from the end on fixed end 23c side of arm 31a is formed, and first protrusion 37 protruding toward the side (in other words, the X-axis minus side) opposite to arm 31a from the end on fixed end 23c side of arm 31b is formed. First protrusions 37 formed at arms 31a and 31b are fitted into first opening parts 44 formed in lever section 40 to be described below. When first protrusions 37 are vided in an axial direction (in the present exemplary embodiment, which is parallel to the X-axis and hereinafter, is referred to as an axial direction) pivotally supported by first protrusions 21c, the outer shapes of first protrusions 37 are substantially circular shapes.

As stated above, arm section 30 is attached to button lower part 60 and power generation device 20. Button 11 is pressed, and thus, button lower part 60 presses arm section 30. As a result, arm section 30 is rotated with first protrusions 21c as the rotary shaft. Arm section 30 is rotated in the Z-axis minus direction by being pressed by button lower part 60. In the present exemplary embodiment, when arm 31a is viewed from an outside of power generation switch 10 in plan view (in other words, when the X-axis minus side is viewed from the X-axis plus side), arm section 30 is rotated in a counterclockwise direction by being pressed by button lower part 60. Arms 31a and 31b are an example of a pair of arms included in arm section 30.

First protrusions 46 of lever section 40 to be described below are fitted into second opening parts 35.

First connecting part 32 connects the ends on free end 23d side of arms 31a and 31b. First connecting part 32 is formed so as to extend in a coupling direction of the ends on free end 23d side of arms 31a and 31b. Accordingly, when arm 31a side of button 11 is operated by the user, arm 31b is rotated in the same direction as arm 31a through first connecting part 32.

Second connecting part 33 connects the ends on fixed end 23c side of arms 31a and 31b. Second connecting part 33 is formed so as to extend in a coupling direction of the ends on fixed end 23c side of arms 31a and 31b.

Magnet 38 is disposed at the ends on free end 23d side of arms 31a and 31b. Specifically, magnet 38 is disposed on power generation device 20 side closer than first connecting part 32 with a predetermined distance between the magnet and first connecting part 32. Accordingly, a space is formed between first connecting part 32 and magnet 38. When arm section 30 is attached to power generation device 20, the end on free end 23d side of power generator 23 is disposed in the space between first connecting part 32 and magnet 38. That is, magnet 38 is disposed at the ends on free end 23d side of arms 31a and 31b such that the end on free end 23d side of power generator 23 is sandwiched between magnet 38 and first connecting part 32.

In plan view, magnet 38 is disposed at an overlapping position with magnetic plate 23a disposed at the end on free end 23d side of power generator 23. For example, magnet 38 is disposed so as to be in contact with the end on free end 23d side of power generator 23 in a state in which power generator 23 is not bent (specifically, a state in which the user does not operate button 11, and hereinafter, is referred to as an initial state). In other words, magnet 38 is attracted to magnetic plate 23a by a magnetic force in the initial state.

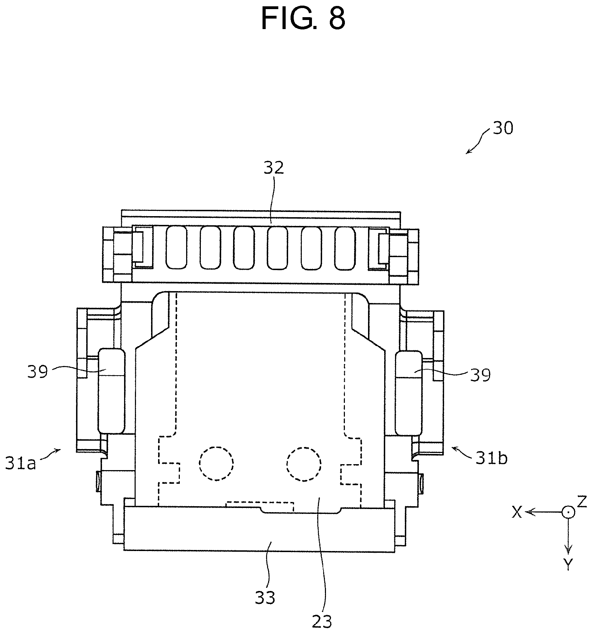

Next, inclined parts 39 formed at arm section 30 will be described with reference to FIG. 8.

FIG. 8 is a plane view illustrating an appearance of arm section 30 according to the present exemplary embodiment. Specifically, FIG. 8 is a plane view when arm 30 is viewed from button lower part 60 side. In FIG. 8, power generator 23 is depicted by a broken line.

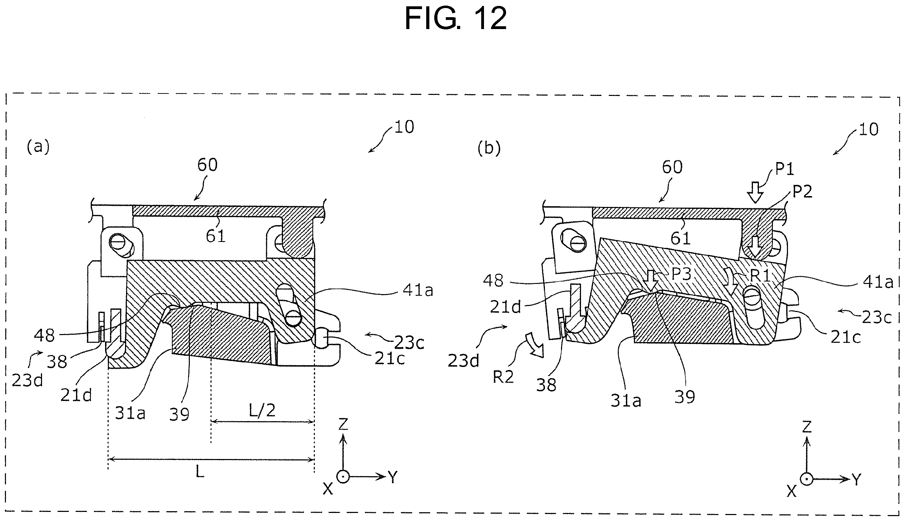

As illustrated in FIG. 8, inclined parts 39 are respectively formed near centers of arms 31a and 31b. For example, inclined parts 39 are formed at positions so as not to be overlapped with power generator 23 in plan view. When viewed in the axial direction, inclined parts 39 are formed so as to have predetermined inclines. When viewed in the axial direction, inclined parts 39 are inclined so as to be away from top plate 61 toward free end 23d side from fixed end 23c side (see FIG. 12).

Arm section 30 is made of a resin material. For example, arm 30 is made of an acrylic resin, a polycarbonate resin, polybutylene terephthalate (PBT), polyoxymethylene (POM), or an ABS resin (a copolymer of acrylonitrile, butadiene, and styrene). For example, the components constituting arm section 30 may be integrally formed.

### [1-1-4. Lever section]

Next, lever section 40 will be described with reference to FIGS. 3 and 4.

As illustrated in FIG. 3, lever section 40 is covered by button lower part 60. Accordingly, button lower part 60 is pressed, and thus, lever section 40 can be pressed and rotated.

As illustrated in FIG. 4, lever section 40 includes arm 41a, arm 41b, first connecting part 42, and second connecting part 43. First opening parts 44 and second opening parts 45 are formed on fixed end 23c side of arms 41a and 41b. Second opening parts 45 are formed at positions on button lower part 60 side closer than first opening parts 44.

Arms 41a and 41b extend in the coupling direction of free end 23d and fixed end 23c of power generator 23, and are arranged in substantially parallel to each other. In plan view, arms 41a and 41b are arranged in parallel with each other in a direction perpendicular to the coupling direction of free end 23d and fixed end 23c so as to sandwich power generator 23. When viewed in the axial direction, arms 41a and 41b are arranged so as to overlap arm section 30 (specifically, arms 31a and 31b).

Ends on fixed end 23c side of arms 41a and 41b are fixed to button lower part 60. Specifically, second opening parts 45 formed in arms 41a and 41b and second protrusions 64 (see FIG. 9) formed at button lower part 60 are fitted, and thus, lever section 40 and button lower part 60 are attached.

First protrusions 37 formed at arm section 30 described above are fitted into first opening parts 44 formed in arms 41a and 41b. In plan view, first protrusions 46 protruding outward of power generation switch 10 are formed in arms 41a and 41b. Specifically, first protrusions 46 protruding toward a side (in other words, the X-axis plus side) opposite to arm 41b are formed at positions of arm 41a corresponding to second opening parts 35 of arm 31a, and first protrusions 46 protruding toward a side (in other words, the X-axis minus side) opposite to arm 41a are formed at positions of arms 41b corresponding to second opening parts 35 of arm 31b. First protrusions 46 formed at arms 41a and 41b are fitted into second opening parts 35. Accordingly, lever section 40 and arm section 30 are attached. When first protrusions 46 are viewed in the axial direction, the outer shapes of first protrusions 46 are substantially circular shapes.

The ends on free end 23d side of arms 41a and 41b are attached to power generation device 20 so as to be rotated. Specifically, curves 47 having curved shapes corresponding to the substantially circular shapes of second protrusions 21d of power generation device 20 in plan view are formed at the ends on free end 23d side of arms 41a and 41b. Curves 47 are arranged so as to abut on second protrusions 21d.

As stated above, lever section 40 is attached to button lower part 60 and power generation device 20. Button 11 is pressed, and thus, button lower part 60 presses lever section 40. As a result, lever section 40 is rotated with second protrusions 21d as the rotary shaft. Lever section 40 is rotated toward the Z-axis minus side by being pressed by button lower part 60. In the present exemplary embodiment, when arm 41a is viewed from the outside of power generation switch 10 in plan view (in other words, when the X-axis minus side is viewed from the X-axis plus side), lever section 40 is rotated in a clockwise direction by being pressed by button lower part 60. That is, when the lever section is pressed by button lower part 60, lever section 40 is rotated in an orientation opposite to arm section 30. Arms 41a and 41b are an example of a pair of arms included in lever section 40.

Arms 41a and 41b include second protrusions 48 protruding toward a direction (in other words, the Z-axis minus direction) facing inclined parts 39 at positions overlapped with inclined parts 39 in plan view. That is, when viewed in the axial direction, second protrusions 48 are formed on top plate 61 side closer than inclined parts 39. The details of second protrusions 48 will be described below. Second protrusions 48 are examples of projections.

Lever section 40 is made of a resin material. For example, lever section 40 is made of an acrylic resin, a polycarbonate resin, polybutylene terephthalate (PBT), polyoxymethylene (POM), or an ABS resin (a copolymer of acrylonitrile, butadiene, and styrene). For example, the components constituting lever section 40 may be integrally formed.

### [1-1-5. Cover]

Next, cover 50 will be described with reference to FIG. 4.

As illustrated in FIG. 4, cover 50 is disposed so as to cover arm section 30 and lever section 40. When a connection member in which power generation device 20, arm section 30, and lever section 40 are fitted and connected is accommodated in case 12 (see FIG. 1), cover 50 is a member that covers the connection member from button 11 side (see FIG. 1). Side surface 12b of case 12 and a side surface of cover 50 are fitted, and thus, cover 50 is fixed to case 12.

In cover 50, openings are formed at positions corresponding to the end on free end 23d side of arm section 30 and the end on fixed end 23c side of lever section 40. Accordingly, arm section 30 and button lower part 60, and lever section 40 and button lower part 60 can be connected.

Cover 50 is made of a resin material. For example, cover 50 is made of an acrylic resin, a polycarbonate resin, polybutylene terephthalate (PBT), polyoxymethylene (POM), or an ABS resin (a copolymer of acrylonitrile, butadiene, and styrene).

Case 12 accommodates a part of lever section 40, arm section 30, and power generation device 20 in a state in which cover 50 is fixed to case 12.

### [1-1-6. Button lower part]

Next, button lower part 60 will be described with reference to FIGS. 3, 4, and 9.

As illustrated in FIG. 3, button lower part 60 is disposed so as to cover arm section 30 and lever section 40.

As illustrated in FIG. 4, button lower part 60 includes top plate 61 and side surface 62. A shape of bottom lower part 60 in plan view is a substantially rectangular shape of which corners are cut out.

Top plate 61 is formed substantially parallel to upper surface 11a of button 11. For example, top plate 61 and upper surface 11a are bonded by an adhesive tape, and thus, button lower part 60 and button 11 are fixed. That is, when the user presses button 11 (specifically, upper surface 11a of button 11), button lower part 60 is pressed together with button 11.

Hereinafter, the connection of top plate 61, arm section 30, and lever section 40 will be described with reference to FIG. 9.

FIG. 9 is a plane view illustrating an appearance of button lower part 60 according to the present exemplary embodiment. Specifically, FIG. 9 is a plane view when button lower part 60 side is viewed from power generation device 20 side.

As illustrated in FIG. 9, first protrusions 63 are formed on free end 23d side (Y-axis minus side) of top plate 61 of button lower part 60, and second protrusions 64 are formed on fixed end 23c side (Y-axis plus side).

First protrusions 63 are protrusions for attaching arm section 30 and button lower part 60. Specifically, first opening parts 34 of arm section 30 and first protrusions 63 are fitted, and thus, arm section 30 and button lower part 60 are attached.

Second protrusions 64 are protrusions for attaching lever section 40 and button lower part 60. Specifically, second protrusions 64 are inserted into second opening parts 45 of lever section 40, and thus, lever section 40 and button lower part 60 are attached.

A case where button lower part 60 to which arm section 30 and lever section 40 are attached is pressed by operating button 11 as stated above will be described. When free end 23d side of button 11 is pressed, free end 23d side of button 11 and button lower part 60 are mainly pressed. Accordingly, arm section 30 connected to free end 23d side of top plate 61 is pressed, and thus, arm section 30 is rotated with first protrusions 21c as the rotary shaft. When fixed end 23c side of button 11 is pressed, fixed end 23c side of button 11 and button lower part 60 are mainly pressed. Accordingly, lever section 40 connected to fixed end 23c side of top plate 61 is pressed, and thus, lever section 40 is rotated with second protrusions 21d as the rotary shaft.

When a central portion of button 11 is pressed, both arm section 30 and lever section 40 are pressed, and thus, both the arm section and the lever section are rotated. That is, top plate 61 is disposed at a position covering arm section 30 and lever section 40 such that button 11 presses and rotates at least one of arm section 30 and lever section 40 depending on the pressed position of button 11.

Hereinafter, referring back to FIG. 4, the button lower part will be described. Side surface 62 is formed vertically toward power generation device 20 side from the end of top plate 61. Claws 62a protruding toward power generation device 20 side are formed at four corners of side surface 62. Claws 62a are protrusions for attaching case 12 and button lower part 60. Recesses (not illustrated) are formed at positions of the side surface of case 12 corresponding to claws 62a, and claws 62a are hooked to the recesses. Thus, button lower part 60 is restrained from being separated from case 12. The recesses are formed such that button lower part 60 can be pressed and can move toward case 12.

Button lower part 60 is made of a resin material. For example, button lower part 60 is made of an acrylic resin, a polycarbonate resin, polybutylene terephthalate (PBT), polyoxymethylene (POM), or an ABS resin (a copolymer of acrylonitrile, butadiene, and styrene). For example, the components constituting button lower part 60 may be integrally formed.

As stated above, power generation switch 10 according to the present exemplary embodiment includes arm section 30 of which the end on fixed end 23c side is pivotally supported and lever section 40 which overlaps arm section 30 and of which the end on free end 23d side is pivotally supported. Although the details will be described below, when lever section 40 is rotated, arm section 30 is pressed and rotated.

### [1-2. Operation of power generation switch]

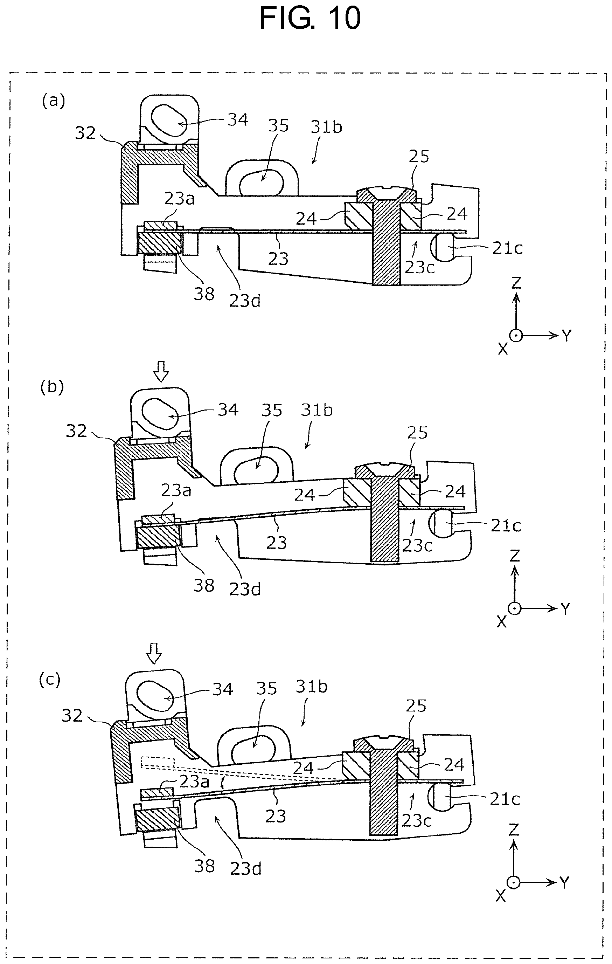

Next, an operation when power generation switch 10 according to the present exemplary embodiment is operated will be described with reference to FIGS. 10 to 12.

Initially, a case where power generation device 20 generates the power by operating button 11 will be described with reference to FIG. 10.

FIG. 10 is a cross-sectional view for describing a case where power generator 23 generates the power by rotating arm section 30 according to the present exemplary embodiment. In FIG. 10, first protrusions 21c included in holder section 21, screw holder 24, and screws 25, and arm section 30 (specifically, arm 31b, first connecting part 32, and magnet 38) are illustrated.

Part (a) of FIG. 10 illustrates a state before button 11 is operated. That is, part (a) of FIG. 10 illustrates the initial state.

As illustrated in part (a) of FIG. 10, in the initial state, power generator 23 is not bent. Magnet 38 is disposed so as to abut on the end on free end 23d side (Y-axis minus side) of power generator 23. In the present exemplary embodiment, magnet 38 is disposed so as to abut on the surface opposite to magnetic plate 23a with power generator 23 interposed therebetween. This state is a state in which magnet 38 is attracted to magnetic plate 23a. Magnetic plate 23a may be disposed on the surface on the Z-axis minus side of free end 23d. In this case, magnetic plate 23a and magnet 38 are attracted by the magnetic force, and magnetic plate 23a and magnet 38 are arranged so as to abut on each other.

Part (b) of FIG. 10 is a diagram illustrating bending of power generator 23 when free end 23d side of button 11 is operated.

As illustrated in part (b) of FIG. 10, when free end 23d side of button 11 is operated (see an arrow in the drawing), since arm section 30 (arm 31b in part (b) of FIG. 10) is rotated, magnet 38 fixed to free end 23d side of arm section 30 is also rotated. Since magnet 38 and magnetic plate 23a are attracted by the magnetic force, free end 23d side of power generator 23 is bent in the orientation of the rotation of magnet 38 according to the rotation of magnet 38.

Part (c) of FIG. 10 is a diagram illustrating the free vibration of power generator 23 when magnet 38 is separated from power generator 23.

As illustrated in part (c) of FIG. 10, when a reaction force generated by bending is larger than an attractive force generated by the magnetic force between magnet 38 and magnetic plate 23a, magnet 38 and power generator 23 are separated, and power generator 23 starts the free vibration. That is, magnet 38 is in a state of being released from an state of being attracted to magnetic plate 23a. Power generator 23 generates the power due to the free vibration. In part (c) of FIG. 10, an example of power generator 23 that is freely vibrating is represented by a broken line.

A case where the component is "viewed in the Z-axis direction (in other words, in plan view)" may be referred to as a case where the component is "viewed in a direction in which the power generator freely vibrates".

As stated above, power generator 23 freely vibrates by rotating arm section 30, and thus, power generation switch 10 according to the present exemplary embodiment generates the power. Thus, it is possible to transmit the predetermined signal by using the power generated by power generator 23 without using the battery.

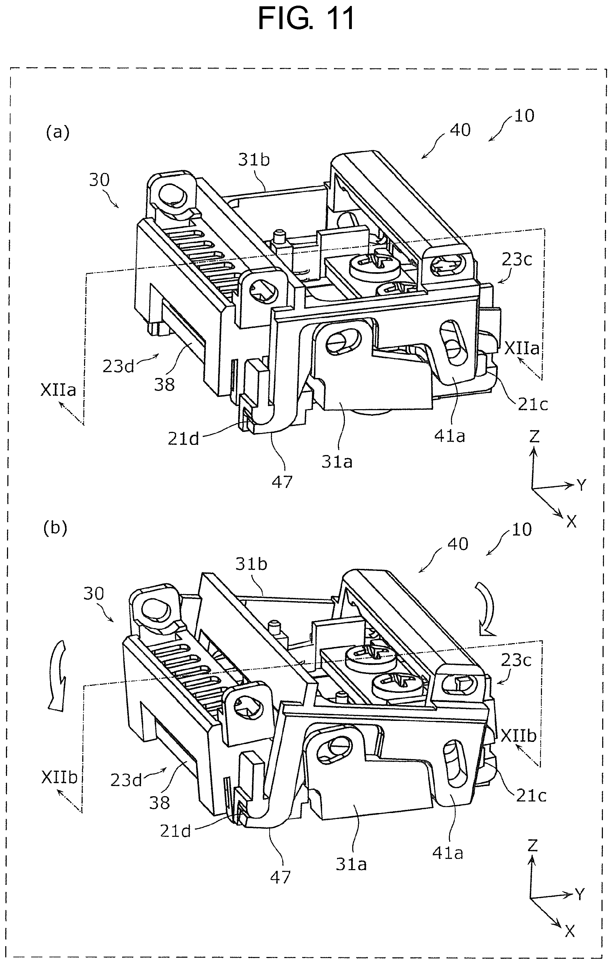

Next, an outline of operations of arm section 30 and lever section 40 will be described with reference to FIG. 11. In FIG. 11, button 11, case 12, and button lower part 60 are omitted.

FIG. 11 is a diagram illustrating the outline of the operations of arm section 30 and lever section 40 when button 11 according to the present exemplary embodiment is operated. Specifically, part (a) of FIG. 11 is a diagram illustrating states of arm section 30 and lever section 40 before button 11 is operated. A state before button 11 is operated means the initial state. Part (b) of FIG. 11 is a diagram illustrating the states of arm section 30 and lever section 40 when button 11 is operated and arm section 30 and lever section 40 are rotated. As illustrated in part (b) of FIG. 11, in power generation switch 10 according to the present exemplary embodiment, when button 11 is operated and arm 41a is viewed in an orientation (in other words, an orientation toward the X-axis minus side from the X-axis plus side) in which arm 41a is viewed from the outside of power generation switch 10 in plan view, arm 41a is rotated in the counterclockwise direction with first protrusions 21c as the rotary shaft, and lever section 40 is rotated in the clockwise direction with second protrusions 21d as the rotary shaft.

The details of the operations of arm section 30 and lever section 40 will be described.

Initially, when free end 23d side of button 11 is operated, arm section 30 is rotated and magnet 38 is released from the attraction due to the magnetic force between the magnet and magnetic plate 23a as described with reference to FIG. 10, and thus, power generator 23 freely vibrates and generates the power.

Next, a case where free end 23c side of button 11 is operated will be described with reference to FIG. 12.

FIG. 12 is a schematic cross-sectional view of power generation switch 10 according to the present exemplary embodiment in the state of FIG. 11, and illustrates the states of arm section 30 and lever section 40 when fixed end 23c side of button 11 is operated. In FIG. 12, button lower part 60 is also illustrated.

Part (a) of FIG. 12 is a schematic cross-sectional view of power generation switch 10 according to the present exemplary embodiment taken along line XIIa-XIIa of part (a) of FIG. 11, and is a schematic cross-sectional view illustrating the state of power generation switch 10 before button 11 is operated.

As illustrated in part (a) of FIG. 12, before button 11 is operated, that is, in the initial state in which button lower part 60 is not pressed, inclined parts 39 of arm section 30 have predetermined inclines with respect to top plate 61. The predetermined incline is an incline such that a distance between top plate 61 becomes gradually larger from fixed end 23c side of inclined parts 39 toward free end 23d side when viewed in the axial direction.

A shape of a tip of second protrusion 48 of lever section 40 has curvature when viewed in the axial direction. For example, second protrusion 48 may have a substantially convex dome shape on power generation device 20 side, and may have a substantially semicircular shape (kamaboko shape).

In such a state, a case where fixed end 23c side of button 11 is operated will be described with reference to part (b) of FIG. 12.

Part (b) of FIG. 12 is a schematic cross-sectional view of power generation switch 10 according to the present exemplary embodiment taken along line XIIb-XIIb of part (b) of FIG. 11, and is a schematic cross-sectional view illustrating the state of power generation switch 10 when fixed end 23c of button 11 is operated.

Button 11 is operated by the user, and thus, top plate 61 is pressed as represented by arrow P1 in the drawing. A contact point between button lower part 60 and lever section 40 is a force application point, and button lower part 60 presses lever section 40 as represented by arrow P2 in the drawing. Accordingly, lever section 40 is rotated in an orientation of arrow R1 with second protrusions 21d as the rotary shaft.

As described above, in the present exemplary embodiment, inclined parts 39 and second protrusions 48 abut on each other in the initial state. Lever section 40 is rotated, and thus, second protrusions 48 press inclined parts 39 downward (Z-axis minus direction) as represented by arrow P3 in the drawing. For example, lever section 40 is rotated, and thus, second protrusions 48 press inclined parts 39 while sliding on the inclined parts. Accordingly, arm section 30 is pressed. In this case, arm section 30 is rotated in an orientation of arrow R2 with first protrusions 46 as the rotary shaft. The orientation of arrow R2 is the same as an orientation in which arm section 30 is rotated when free end 23d side of button 11 is operated. That is, the orientation of arrow R2 is an orientation in which power generator 23 freely vibrates and generates the power.

In parts (a) and (b) of FIG. 12, arm 31a and arm 41a arranged on the X-axis plus side are illustrated, but second protrusions 48 and inclined parts 39 are similarly formed at arm 31b and arm 41b arranged on the X-axis minus side. The ends on fixed end 23c side of arms 41a and 41b of lever section 40 are connected by first connecting part 42.

For example, when a position on fixed end 23c side of button 11 which is close to a position at which arm 41a of lever section 40 and top plate 61 are fitted is operated in plan view, arm 41a of lever section 40 is pressed, and arm 41b connected to arm 41a by first connecting part 42 is also pressed. That is, arms 41a and 41b are pressed even though any position on fixed end 23c side of button 11 is operated. In other words, lever section 40 is pressed and rotated even though any position on fixed end 23c side of button 11 (specifically, top plate 61) is operated. Accordingly, arm section 30 is also rotated.

As stated above, in accordance with power generation switch 10 according to the present exemplary embodiment, arm section 30 can be rotated irrespective of the operated position of button 11. That is, power generator 23 can generate the power.

When fixed end 23c side is operated, contact points between inclined parts 39 of arm section 30 and second protrusions 48 of lever section 40 become action points at which arm section 30 is pressed, and second protrusions 21d become branch points. As a distance between the action point and the force application point becomes shorter, it is possible to rotate arm section 30 with a smaller force. Thus, the contact points between inclined parts 39 and second protrusions 48 are preferably close to second protrusions 21d. For example, as illustrated in part (a) of FIG. 12, in a case where a length of lever section 40 when viewed in the axial direction is L, inclined parts 39 and second protrusions 48 are arranged on free end 23d side closer than a position of L/2 from the end on fixed end 23c side of lever section 40. That is, when viewed in the axial direction, inclined parts 39 and second protrusions 48 are arranged on free end 23d side of free end 23d side and fixed end 23c side of lever section 40. In the present exemplary embodiment, inclined parts 39 and second protrusions 48 abut on each other in the initial state, but the present exemplary embodiment is not limited thereto.

### [1-3. Effects]

As stated above, power generation device 20 according to the present exemplary embodiment has a cantilever structure in which one end is fixed end 23c to be fixed and the other end is free end 23d, and includes power generator 23 that generates a power by the free vibration of free end 23d, resin holder section 21 on which power generator 23 is mounted, and metal rigid plate 27 that is disposed on an opposite side to power generator 23 with holder section 21 interposed therebetween. Fixed end 23c and holder section 21 are fixed, and holder section 21 and rigid plate 27 are fixed.

Accordingly, it is possible to increase a weight of power generation device 20 compared to a case where rigid plate 27 is not provided. Rigid plate 27 is disposed on an opposite side to power generator 23, and thus, it is possible to increase a size of rigid plate 27 compared to a case where the rigid plate is disposed on the same surface as power generator 23. Thus, since the weight of power generation device 20 is efficiently increased, the free vibration of power generator 23 can be further continued as compared to the related art. In other words, in accordance with power generation device 20 according to the present exemplary embodiment, it is possible to further restrain the free vibration of power generator 23 from being attenuated compared to the related art.

Fixed end 23c, holder section 21, and rigid plate 27 are overlapped in contact with each other in this order, and are fixed by using common fixing members. The fixing members are screws 25 for penetrating through and fixing fixed end 23c, holder section 21, and rigid plate 27.

For example, when fixed end 23c of power generator 23 is fastened to resin holder section 21 by using a self-tapping screw, a fastening force is non-uniform due to variations in the crushing of holder section 21, and the continuity of the free vibration is hindered. Meanwhile, in the present exemplary embodiment, fixed end 23c, holder section 21, and metal rigid plate 27 are fastened by being penetrated by screws 25, and thus, it is possible to improve the fastening force of power generator 23 and holder section 21. Accordingly, it is possible to further continue the free vibration of power generator 23.

Case 12 (an example of a housing) that accommodates power generator 23, holder section 21, and rigid plate 27 is further provided, and case 12 and rigid plate 27 are fixed by screws 25.

Accordingly, since it is possible to improve the fastening force compared to a case where case 12 is fastened to resin holder section 21, it is possible to restrain the free vibration from being attenuated by the variations in fastening force of case 12 and holder section 21.

Recess 21g (see FIG. 7) corresponding to the shape of rigid plate 27 is formed on the surface of the holder section 21 at the side on which rigid plate 27 is disposed, and rigid plate 27 is accommodated in recess 21g.

Accordingly, it is possible to increase the weight of power generation device 20 while restraining the size of power generation device 20 from being increased.

Rigid plate 27 is made of a non-magnetic material.

Accordingly, it is possible to restrain the influence of rigid plate 27 on the free vibration of power generator 23.

Magnetic plate 23a (an example of an attraction member) fixed to free end 23d, and arm section 30 that includes magnet 38 which extends in the coupling direction of free end 23d and fixed end 23c and enters a state of being attracted to magnetic plate 23a by the magnetic force by pivotally supporting and rotating the end on fixed end 23c side or a state of being released from the attracted state are further provided.

Accordingly, power generation device 20 can be used as the power generation switch.

As stated above, power generation switch 10 according to the present exemplary embodiment includes holder section 21, power generator 23 that includes fixed end 23c which is fixed to holder section 21 and free end 23d which freely vibrates, and generates a power due to the free vibration of free end 23d, power generator 23 including magnetic plate 23a (an example of an attraction member), arm section 30 that extends in a coupling direction of free end 23d and fixed end 23c, and includes magnet 38 which enters a state of being attracted to magnetic plate 23a by a magnetic force by pivotally supporting and rotating an end on fixed end 23c side or a state of being released from the attracted state, lever section 40 that extends in the coupling direction of free end 23d and fixed end 23c so as to overlap arm section 30 when viewed in an axial direction in which the end is pivotally supported, and presses and rotates arm section 30 by pivotally supporting and rotating an end on free end 23d side, and top plate 61 that presses and rotates at least one of arm section 30 and lever section 40 depending on a pressed position.

Accordingly, top plate 61 is operated and pressed, and thus, it is possible to directly rotate arm section 30 or it is possible to rotate the arm section through lever section 40. For example, when lever section 40 is not included, it is difficult to rotate arm section 30 by operating fixed end 23c side of arm section 30. Meanwhile, in accordance with power generation switch 10 according to the present exemplary embodiment, it is possible to rotate arm section 30 irrespective of the position (in the present exemplary embodiment, the position in the Y-axis direction) in the direction parallel to the coupling direction of free end 23d and fixed end 23c at which top plate 61 is operated. That is, in accordance with power generation switch 10 according to the present exemplary embodiment, operability is improved.

Arm section 30 includes inclined part 39 which is disposed at a position at which the inclined part is not overlapped with power generator 23 when viewed in a direction in which power generator 23 freely vibrates, and has a predetermined incline when viewed in the axial direction in which the end is pivotally supported, and lever section 40 includes second protrusion 48 (an example of a projection) which is disposed at a position at which the protrusion is overlapped with inclined part 39 when viewed in the direction in which the power generator freely vibrates and is on top plate 61 side closer than inclined part 39 when viewed in the axial direction in which the end is pivotally supported.

Accordingly, when lever section 40 is rotated by top plate 61, second protrusion 48 can press inclined part 39. That is, lever section 40 is rotated, and thus, it is possible to press and rotate arm section 30.

Inclined part 39 and second protrusion 48 are disposed on free end 23d side of free end 23d side and fixed end 23c side of lever section 40.

Accordingly, when arm section 30 is pressed and rotated by operating fixed end 23c side of top plate 61 and rotating lever section 40, the user can rotate arm section 30 even though the user operates the arm section with a weak force compared to a case where inclined part 39 and second protrusion 48 are arranged on fixed end 23c side. That is, the operability of power generation switch 10 is further improved.

A shape of a tip of second protrusion 48 has curvature when viewed in the axial direction in which the end is pivotally supported.

Accordingly, since a contact area between second protrusion 48 and inclined part 39 becomes small, it is possible to reduce a frictional resistance when lever section 40 is rotated and second protrusion 48 slides on inclined part 39. That is, second protrusion 48 easily slides on inclined part 39. Thus, the user can rotate arm section 30 even though the user operates the arm section with a weak force. That is, the operability of power generation switch 10 is further improved.

When arm section 30 and lever section 40 are not pressed by top plate 61, second protrusion 48 and inclined part 39 abut on each other.

Accordingly, when lever section 40 is pressed by top plate 61 and starts to be rotated, lever section 40 can start the rotation of arm section 30 through inclined part 39. That is, it is possible to substantially simultaneously start the rotation of lever section 40 and the rotation of arm section 30 through lever section 40.

Free end 23d side of arm section 30 and fixed end 23c side of lever section 40 are fitted to top plate 61.

Accordingly, since arm section 30, lever section 40, and top plate 61 abut on each other, top plate 61 easily presses and rotates arm section 30 and lever section 40. It is possible to restrain top plate 61 from being separated from power generation switch 10.

Arm section 30 includes arms 31a and 31b (an example of a pair of arms included in arm section 30) which extend in the coupling direction of free end 23d and fixed end 23c, which are parallel to each other to sandwich power generator 23, and of which ends on fixed end 23c side are pivotally supported. Lever section 40 includes arms 41a and 41b (an example of a pair of arms included in lever section 40) which extend in the coupling direction of free end 23d and fixed end 23c so as to overlap arm section 30, which are parallel to each other to sandwich power generator 23, and of which ends on free end 23d side are pivotally supported.

Accordingly, in accordance with power generation switch 10 according to the present exemplary embodiment, it is possible to rotate arm section 30 irrespective of a position (for example, a position in the X-axis direction) in a direction parallel to a width direction of power generator 23 at which top plate 61 is operated. That is, in accordance with power generation switch 10 according to the present exemplary embodiment, operability is further improved.

Power generator 23 includes two piezoelectric elements 23f and 23g, and metal plate 23e, and two piezoelectric elements 23f and 23g are arranged so as to sandwich metal plate 23e.

Accordingly, it is possible to further increase the power generated by the free vibration of power generator 23 compared to a case where one piezoelectric element is used.

### (Second exemplary embodiment)

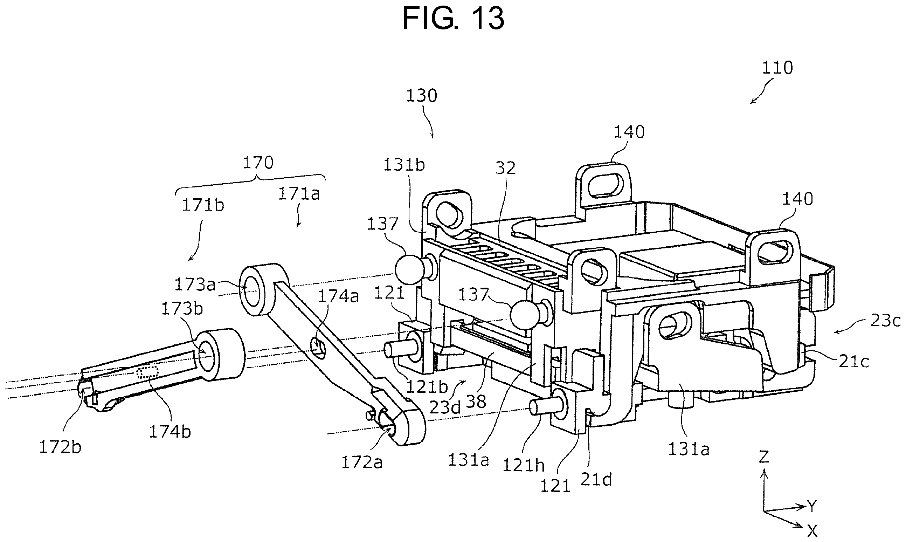

Next, power generation switch 110 according to the present exemplary embodiment will be described with reference to FIGS. 13 to 15. Differences from the first exemplary embodiment will be mainly described in the present exemplary embodiment. The substantially identical configurations as the configurations of the first exemplary embodiment are assigned the same reference marks, and the description will be omitted or simplified.

### [2-1. Entire configuration of power generation switch]

Initially, a configuration of power generation switch 110 according to the present exemplary embodiment will be described with reference to FIG. 13.

FIG. 13 is a partial exploded perspective view illustrating the configuration of power generation switch 110 according to the present exemplary embodiment. In FIG. 13, button 11, case 12, and button lower part 60 are omitted. Button lower part 60 (specifically, top plate 61) is disposed so as to cover arm section 130 and lever section 140 as in the first exemplary embodiment.

As illustrated in FIG. 13, holder section 121, arm section 130, and lever section 140 of power generation switch 110 according to the present exemplary embodiment are different from holder section 21, arm section 30, and lever section 40 according to the first exemplary embodiment. Power generation switch 110 according to the present exemplary embodiment is characterized in that reinforcement arm section 170 is provided.

Hereinafter, the components constituting power generation switch 110 will be descried with appropriate reference to the drawings.

### [2-1-1. Holder section]

Holder section 121 will be described.

As illustrated in FIG. 13, holder section 121 includes third protrusions 121h in addition to the configurations of holder section 21 according to the first exemplary embodiment. The third protrusions 121h are protrusions protruding toward reinforcement arm section 170 side (in other words, from the Y-axis plus side to the Y-axis minus side) from the ends on free end 23d side of second protrusions 21d. Third protrusions 121h are formed at second protrusions 21d formed at both ends on free end 23d side of holder section 121. For example, when third protrusions 121h are viewed in an orientation (in other words, an orientation toward the Y-axis plus side from the Y-axis minus side) in which free end 23d side of power generation switch 110 is viewed from an outside of power generation switch 110 in plan view, outer shapes of third protrusions 121h are substantially circular shapes.

### [2-1-2. Arm section]

Next, arm section 130 will be described.

As illustrated in FIG. 13, arm section 130 includes second protrusions 137 in addition to the configurations of arm section 30 according to the first exemplary embodiment. Second protrusions 137 are protrusions protruding from the ends on free end 23d side of arms 131a and 131b (an example of a pair of arms) toward reinforcement arm section 170 side. For example, tips of second protrusions 137 have substantially spherical shapes. Second protrusions 137 are formed on the Z-axis plus side closer than third protrusions 121h of holder section 121.

### [2-1-3. Lever section]

Next, lever section 140 will be described.

As illustrated in FIG. 13, lever section 140 may not include first connecting part 42 included in lever section 40 according to the first exemplary embodiment.

### [2-1-4. Reinforcement arm section]

Next, reinforcement arm section 170 will be described.

As illustrated in FIG. 13, reinforcement arm section 170 is disposed on free end 23d side of power generation switch 110. Reinforcement arm section 170 is a reinforcement member for reinforcing arm section 130. Reinforcement arm section 170 includes reinforcement arms 171a and 171b (an example of two reinforcement arms).

Reinforcement arms 171a and 171b extend so as to intersect each other in a direction substantially parallel to a coupling direction (in other words, the X-axis direction) of the ends on free end 23d side of arms 131a and 131b of arm section 130.

Reinforcement arm 171a includes first opening part 172a in one end of both ends, and second opening part 173a in the other end. When reinforcement arm 171a is viewed in an orientation (an orientation toward the Y-axis plus side from the Y-axis minus side) in which free end 23d side of power generation switch 110 is viewed from the outside of power generation switch 110 in plan view, an outer shape of first opening part 172a is a substantially oval shape of which a major axis is a direction in which reinforcement arm 171a extends, and an outer shape of second opening part 173a is a substantially circular shape corresponding to the shape of second protrusion 137.

Third protrusion 121h formed at the X-axis plus side of holder section 121 is fitted into first opening part 172a. Second protrusion 137 formed at arm 131b is fitted into second opening part 173a. Accordingly, reinforcement arm 171a is attached to holder section 121 and arm section 130. Reinforcement arm 171a is pivotally supported by third protrusions 121h, and is attached so as to be rotated with third protrusions 121h as the rotary shaft. For example, when arm 131b side of arm section 130 is pressed and rotated and reinforcement arm 171a is viewed in an orientation in which free end 23d side of power generation switch 110 is viewed from the outside of power generation switch 110 in plan view, reinforcement arm 171a is rotated in the counterclockwise direction with third protrusions 121h as the rotary shaft.

When free end 23d side is viewed from the outside of power generation switch 110 in plan view, reinforcement arm 171a includes third opening part 174a having an outer shape which is a substantially oval shape of which a major axis is a direction substantially parallel to a direction in which reinforcement arm 171a extends at a position at which reinforcement arms 171a and 171b intersect. Third opening part 174a is an example of a recess.

Reinforcement arm 171b includes first opening part 172b in one end of both ends, and second opening part 173b in the other end. When reinforcement arm 171b is viewed in an orientation in which free end 23d side of power generation switch 110 is viewed from the outside of power generation switch 110 in plan view, an outer shape of first opening part 172b is a substantially oval shape of which a major axis is a direction in which reinforcement arm 171b extends, and an outer shape of second opening part 173b is a substantially circular shape corresponding to the shape of second protrusion 137.

Third protrusion 121h formed on the X-axis minus side of holder section 121 is fitted into first opening part 172b. Second protrusion 137 formed at arm 131a is fitted into second opening 173b. Accordingly, reinforcement arm 171b is attached to holder section 121 and arm section 130. Reinforcement arm 171b is pivotally supported by third protrusion 121h, and is attached so as to be rotated with third protrusion 121h as the rotary shaft. For example, when arm 131a side of arm section 130 is pressed and rotated and reinforcement arm 171b is viewed in an orientation in which free end 23d side of power generation switch 110 is viewed from the outside of power generation switch 110 in plan view, reinforcement arm 171b is rotated in the clockwise direction with third protrusion 121h as the rotary shaft. In other words, when arm section 130 is pressed, reinforcement arm 171b is rotated in an orientation opposite to reinforcement arm 171a.

When free end 23d side is viewed from the outside, reinforcement arm 171b includes protrusion 174b of which an outer shape is a substantially circular shape and protrudes toward reinforcement arm 171a at a position at which reinforcement arms 171a and 171b intersect. At least a part of protrusion 174b is inserted into third opening part 174a in a state in which reinforcement arm 171b is attached to holder section 121 and arm section 130. When protrusion 174b does not penetrate through third opening part 174a in a state in which reinforcement arms 171a and 171b are fitted into holder section 121 and arm section 130 respectively, third opening part 174a may not be a through-hole. For example, third opening part 174a may be a recess having an opening on reinforcement arm 171b side.

Reinforcement arm section 170 is made of a resin material. For example, reinforcement arm section 170 is made of an acrylic resin, a polycarbonate resin, polybutylene terephthalate (PBT), polyoxymethylene (POM), or an ABS resin (a copolymer of acrylonitrile, butadiene, and styrene).

As stated above, power generation switch 110 according to the present exemplary embodiment includes reinforcement arms 171a and 171b arranged on free end 23d side of arm section 130 so as to overlap each other. The end of reinforcement arm 171a on top plate 61 side (Z-axis plus side) is fitted to arm 131b, and the end on power generator 23 side (Z-axis minus side) is fitted to holder section 121. The end of reinforcement arm 171b on top plate 61 side is fitted to arm 131a, and the end on power generator 23 side is fitted to holder section 121. Reinforcement arms 171a and 171b are connected at a position at which reinforcement arms 171a and 171b intersect such that the other reinforcement arm (the other one of reinforcement arms 171a and 171b) is pressed when one reinforcement arm (one of reinforcement arms 171a and 171b) is pressed. That is, reinforcement arm section 170 has a cross link mechanism including two reinforcement arms 171a and 171b in line with each other.

### [2-2. Operation of power generation switch]

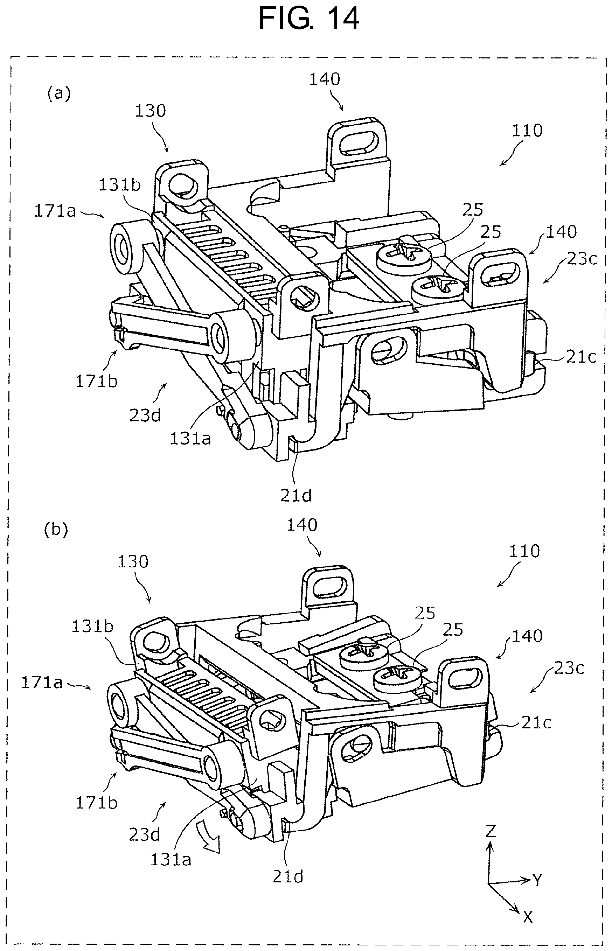

Next, an operation when power generation switch 110 according to the present exemplary embodiment having the aforementioned configuration is operated will be described with reference to FIG. 14. In FIG. 14, button 11, case 12, and button lower part 60 are omitted.

FIG. 14 is a perspective view illustrating an outline of operations of arm section 130 and reinforcement arm section 170 when button 11 according to the present exemplary embodiment is operated. Specifically, part (a) of FIG. 14 is a diagram illustrating a state of arm section 130 before button 11 is operated. A state before button 11 is operated means the initial state. Part (b) of FIG. 14 is a diagram when button 11 is operated and arm section 130 is rotated. For example, part (b) of FIG. 14 is a diagram illustrating the operation of arm section 130 when fixed end 23c side of button 11 is operated. As illustrated in part (b) of FIG. 14, in power generation switch 110 according to the present exemplary embodiment, when button 11 is operated, arm section 130 is rotated with first protrusion 21c as the rotary shaft. In this case, power generation switch 110 is characterized in that reinforcement arm section 170 is provided, and thus, arms 131a and 131b are rotated at the substantially same angle as the angle in the initial state as illustrated in part (b) of FIG. 14.

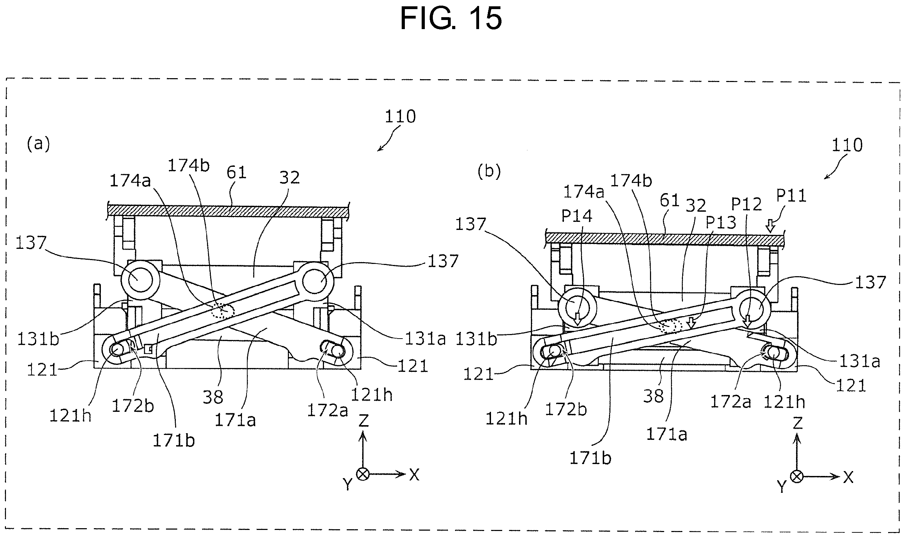

The details of the operations of arm section 130 and reinforcement arm section 170 will be described with reference to FIG. 15.

FIG. 15 is a side view illustrating an outline of operations of arm section 130 and reinforcement arm section 170 when button 11 according to the present exemplary embodiment is operated. In FIG. 15, top plate 61, holder section 121, arm section 130, and reinforcement arm section 170 are illustrated. FIG. 15 is a side view of power generation switch 110 when free end 23d side of power generation switch 110 is viewed from the outside of power generation switch 110.

Part (a) of FIG. 15 is a schematic side view illustrating a state of power generation switch 110 before button 11 is operated. Part (a) of FIG. 15 is a schematic side view in the state of part (a) of FIG. 14.

As illustrated in part (a) of FIG. 15, before button 11 is operated, that is, in the initial state in which button lower part 60 is not pressed, protrusion 174b of reinforcement arm 171b abuts on an inner surface on arm 131a side (in other words, the X-axis plus side) of third opening part 174a of reinforcement arm 171a.

In such a state, a case where arm 131a side of button 11 is operated will be described with reference to part (b) of FIG. 15. Part (b) of FIG. 15 is a schematic side view in the state of part (b) of FIG. 14.

Part (b) of FIG. 15 is a schematic side view illustrating an operation of power generation switch 110 when arm 131a side of button 11 is operated.

Button 11 is operated by the user, and thus, top plate 61 is pressed as represented by arrow P11 in the drawing. Arm 131a attached to top plate 61 is rotated with first protrusion 21c as the rotary shaft. Accordingly, reinforcement arm 171b attached to arm 131a is also pressed as represented in arrow P12 in the drawing. When reinforcement arm 171b is pressed, protrusion 174b presses the inner surface of third opening part 174a as represented by arrow P13 in the drawing. Specifically, protrusion 174b presses the inner surface of third opening part 174a while sliding within third opening part 174a in a direction from arm 131a toward arm 131b. Accordingly, reinforcement arm 171a is pressed as represented by arrow P14 in the drawing. Reinforcement arm 171a is pressed, and thus, arm 131b to which reinforcement arm 171a is attached is also pressed.

As stated above, power generation switch 110 according to the present exemplary embodiment includes reinforcement arm section 170, and thus, arm 131a and arm 131b are rotated at the substantially same angle as the angle in the initial state even when the end side such as arm 131a side of button 11 is operated. For example, when arm 131a side of the button is pressed and the rigidity of first connecting part 32 is low, only arm 131a may be rotated. Accordingly, it is difficult to uniformly bend power generator 23 in the width direction (X-axis direction) of power generator 23. That is, the power generation switch is difficult to stably generate the power even though the user operates button 11. Meanwhile, in the present exemplary embodiment, when one arm (for example, arm 131a) is pressed and rotated, the other arm (for example, arm 131b) is pressed and rotated through reinforcement arm section 170. Accordingly, since it is possible to substantially uniformly bend power generator 23 in the width direction, power generator 23 can perform stable free vibration. That is, power generation switch 110 can stably generate the power.

### [2-3. Effects]

As stated above, power generation switch 110 according to the present exemplary embodiment includes holder section 121, power generator 23 that includes fixed end 23c which is fixed to holder section 21 and free end 23d which freely vibrates, and generates a power due to the free vibration of free end 23d, power generator 23 including magnetic plate 23a (an example of an attraction member), arm section 130 that includes arms 131a and 131b (an example of a pair of arms) which extend in a coupling direction of free end 23d and fixed end 23c, which are parallel to each other to sandwich power generator 23, and of which ends on fixed end 23c side are pivotally supported, first connecting part 32 (an example of a connecting part) which connects ends on free end 23d side of arms 131a and 131b, and magnet 38 which enters a state of being attracted to magnetic plate 23a by a magnetic force by rotating arms 131a and 131b or a state of being released from the attracted state, and reinforcement arm section 170 that includes two reinforcement arms 171a and 171b which extend in a coupling direction of the ends on free end 23d side of arms 131a an 131b when free end 23d side is viewed from an outside, and of which one ends are pivotally supported and the other ends are attached to arms 131a and 131b, reinforcement arm 171b (an example of one reinforcement arm) of two reinforcement arms 171a and 171b being attached to arm 131a (an example of one arm) of arms 131a and 131b such that reinforcement arm 171b is rotated by rotating arm 131a, reinforcement arm 171a (an example of the other reinforcement arm) being connected to reinforcement arm 171b so as to be rotated in an orientation opposite to an orientation of the rotation of reinforcement arm 171b by rotating reinforcement arm 171a, and the other end of the other reinforcement arm being attached to arm 131b.

Accordingly, when one arm (for example, arm 131a) is pressed and rotated, the other arm (for example, arm 131b) is pressed and rotated through reinforcement arm section 170. That is, since it is possible to substantially uniformly bend power generator 23 in the width direction, power generator 23 can perform stable free vibration. Thus, power generation switch 110 can stably generate the power. In other words, power generation switch 110 according to the present exemplary embodiment can rotate arm section 130 (specifically, arms 131a and 131b) at the substantially same angle irrespective of the position (for example, the position in the X-axis direction) parallel to the coupling direction of free end 23d side of arms 131a and 131b. That is, in accordance with power generation switch 10 according to the present exemplary embodiment, operability is improved.

Reinforcement arm 171b includes protrusion 174b protruding toward reinforcement arm 171a side at a position intersecting reinforcement arm 171a, reinforcement arm 171a includes third opening part 174a (an example of a recess) at a position corresponding to protrusion 174b, and at least a part of protrusion 174b is inserted into third opening part 174a.

Accordingly, when one reinforcement arm of reinforcement arms 171a and 171b is pressed, the remaining reinforcement arm can also be pressed.

An outer shape of protrusion 174b when free end 23d side is viewed from the outside is a substantially circular shape, and an outer shape of third opening part 174a when free end 23d side is viewed from the outside is a substantially oval shape of which a major axis is a longitudinal direction of reinforcement arm 171a.

Accordingly, since it is possible to reduce a contact area between protrusion 174b and third opening part 174a, protrusion 174b easily slides on third opening part 174a.

The power generation switch further includes lever section 140 that extends in the coupling direction of free end 23d and fixed end 23c so as to overlap arm section 130 when viewed in an axial direction in which arm section 130 is pivotally supported, and includes protrusion 174b which presses and rotates arm section 130 by pivotally supporting and rotating an end on free end 23d side.

Accordingly, even when lever section 140 is pressed, it is possible to rotate arms 131a and 131b at the substantially same angle. Since the rigidity of arm section 130 is improved by reinforcement arm section 170, lever section 140 may not include first connecting part 42 provided in the first exemplary embodiment. That is, it is possible to reduce the amount of material to be used for lever section 140.

The power generation switch includes top plate 61 that covers arm section 130 and lever section 140 such that at least one of arm section 130 and lever section 140 is pressed and rotated depending on a pressed position.

Accordingly, power generation switch 110 includes top plate 61, and arms 131a and 131b can be rotated at the substantially same angle irrespective of the operated position of top plate 61.

Power generator 23 includes two piezoelectric elements 23f and 23g, and metal plate 23e, and two piezoelectric elements 23f and 23g are arranged so as to sandwich metal plate 23e.

Accordingly, it is possible to further increase the power generated by the free vibration of power generator 23 compared to a case where one piezoelectric element is used.

### (Other exemplary embodiments)

The power generation switch according to the exemplary embodiments have been described above based on the exemplary embodiments. However, the present disclosure is not limited to the above exemplary embodiments.

Therefore, not only components essential for solving the problems but also components not essential for solving the problems may be included in the components described in the accompanying drawings and detailed descriptions. Thus, these non-essential components should not be immediately recognized as being essential based on the non-essential components described in the accompanying drawings or detailed descriptions.

In addition, the present disclosure includes modifications which those skilled in the art can obtain by adding changes to the exemplary embodiments described above or modifications implemented by freely combining components and functions described in the exemplary embodiments without deviating from the gist of the present disclosure.

Although it has been described in the present exemplary embodiment that when power generation switch 10 is operated, the lighting device is turned on, the number of electrical devices controlled by operating power generation switch 10 is not limited to one. In the control device, a plurality of electrical devices to be controlled may be set for the identification information of power generation switch 10. For example, the control device may store the identification information of power generation switch 10 in association with control for turning on the lighting device and control for opening the electric curtain. Accordingly, it is possible to control the plurality of electrical devices such as the lighting device and the electric curtain by operating power generation switch 10 only once.

Although it has been described in the exemplary embodiments that power generation switch 10 transmits the predetermined signal whenever the power generation switch is operated, the operation of power generation switch 10 is not limited to the transmission of the signal. For example, an operation such as light emission or sound generation whenever power generation switch 10 is operated may be performed, or other operations may be performed. That is, the purpose of use of the power generated by operating power generation switch 10 is not particularly limited.

Although it has been described in the exemplary embodiments that the shape of power generation switch 10 in plan view is the rectangular shape in which the four corners each have the R shape, the shape of power generation switch 10 in plan view is not limited thereto. The shape of power generation switch 10 in plan view may be a triangle shape, a trapezoid shape, an oval shape, or may be other shapes. Accordingly, when multiple users use power generation switch 10, it is possible to use the power generation switch 10 while changing the shape thereof for each user. Accordingly, it is possible to improve the convenience of power generation switch 10.

Although it has been described in the exemplary embodiments that magnetic plate 23a made of the magnetic material is used as the attraction member, the present disclosure is not limited thereto. The attraction member may be a magnet. In this case, magnetic poles of the magnet of power generator 23 and magnet 38 of arm section 30 are opposite magnetic poles to each other.

Although it has been described in the exemplary embodiments that rigid plate 27 is accommodated in recess 21g of holder section 21, the present disclosure is not limited thereto. For example, the surface of holder section 21 on rigid plate 27 side may be the smooth surface, and may be fixed such that smooth surface and rigid plate 27 abut on each other.

Although it has been described in the exemplary embodiments that power generator 23 includes magnetic plate 23a and metal plate 23e, the present disclosure is not limited thereto. For example, metal plate 23e may be made of a magnetic metallic material. Accordingly, since metal plate 23e can also serve as magnetic plate 23a, it is possible to reduce the number of components of power generator 23. In this case, metal plate 23e made of the magnetic metallic material is an example of an attraction member. The magnetic metallic material is an example of a magnetic material.

Although it has been described in the exemplary embodiments that power generation switches 10 and 110 are switches capable of being carried, the present disclosure is not limited thereto. For example, power generation switches 10 and 110 may be used for switches fixed to a construction materials such as a wall switch.

Although it has been described in the exemplary embodiments that power generation switch 110 includes lever section 140, power generation switch 110 may not include lever section 140.

### INDUSTRIAL APPLICABILITY

The power generation device according to the present disclosure can be used for a power generation device including a power generator having a cantilever structure which includes a piezoelectric element, and various devices including the power generation device, and is useful for a power generation switch capable of being carried.

### REFERENCE MARKS IN THE DRAWINGS

10, 110: power generation switch
11: button
11a: upper surface
11b, 12b: side surface
12: case
12a: bottom surface
13: screw
20: power generation device
21, 121: holder section
21a: first holder
21b: second holder
21c: first protrusion
21d: second protrusion
21e: first opening part
21f: second opening part
21g: recess
22, 25: screw
23: power generator
23a: magnetic plate (attraction member)
23b: opening part
23c: fixed end
23d: free end
23e: metal plate
23f, 23g: piezoelectric element
23h, 23j: electrode
23i: piezoelectric member
24: screw holder section
26: signal transmitter
26a: substrate
26b: shield case
26c: antenna
27: rigid plate
27a: first opening part
27b: second opening part
27c: third opening part
30, 130: arm section
31a, 31b: arm (pair of arms)
32: first connecting part (connecting part)
33: second connecting part
34: first opening part
35: second opening part
36: third opening part
37: first protrusion
38: magnet
39: inclined part
40, 140: lever section
41a, 41b: arm (pair of arms)
42: first connecting part
43: second connecting part
44: first opening part
45: second opening part
46: first protrusion
47: curve
48: second protrusion (projection)
50: cover
60: button lower part
61: top plate
62: side surface
62a: claw
63: first protrusion
64: second protrusion
121h: third protrusion
131a, 131b: arm (pair of arms)
137: second protrusion
170: reinforcement arm section
171a, 171b: reinforcement arm (pair of reinforcement arms)
172a, 172b: first opening part
173a, 173b: second opening part
174a: third opening part (recess)
174b: protrusion

## Claims

1. A power generation device comprising:
a power generator having a cantilever structure of which one end is a fixed end to be fixed and other end is a free end, the power generator generating a power due to free vibration of the free end;
a holder section comprising resin, the power generator being mounted on; and
a rigid plate comprising metal, the rigid plate being located such that the holder section is between the rigid plate and the power generator, wherein;
the fixed end and the holder section are fixed to each other, and
the holder section and the rigid plate are fixed to each other.

2. The power generation device according to claim 1,
wherein;
the fixed end, the holder section, and the rigid plate are overlapped in contact with each other in this order, and
the fixed end, the holder section, and the rigid plate are fixed to each other by using a fixing member.

3. The power generation device according to claim 2, wherein the fixing member is a screw that fixes the fixed end, the holder section, and the rigid plate by penetrating through the fixed end, the holder section, and the rigid plate.

4. The power generation device according to claim 3, further comprising:
a housing accommodating the power generator, the holder section, and the rigid plate,
wherein the housing and the rigid plate are fixed to each other by a screw.

5. The power generation device according to any one of claims 1 to 4,
wherein;
a recess corresponding to a shape of the rigid plate is formed on a surface of the holder section at a side on which the rigid plate is disposed, and
the rigid plate is accommodated in the recess.

6. The power generation device according to any one of claims 1 to 5, wherein the rigid plate is made of a non-magnetic material.

7. The power generation device according to any one of claims 1 to 6, further comprising:
an attraction member fixed to the free end; and
an arm section extending in a direction from the free end to the fixed end, the arm section pivotally supported on the fixed end, the arm section including a magnet that is attached to or released from the attraction member by the rotation of the magnet.
